# EUROPEAN PATENT APPLICATION

(11) **EP 4 542 861 A1**
(43) Date of publication of application: **23.04.2025**
(21) Application number: 24173722.0
(22) Date of filing: 02.05.2024
(51) Int. Cl.: H03K 17/30

(54) **IDEAL DIODE CIRCUIT**

(30) Priority: 20.10.2023 CN 202311368368
(71) Applicant: Suzhou Watech Electronics Co., Ltd., Suzhou, Jiangsu 215125 (CN)
(72) Inventor: WANG, Rong, Suzhou, 215125 (CN); CHEN, Liang, Suzhou, 215125 (CN)
(74) Representative: Michalski Hüttermann & Partner Patentanwälte mbB

(57) **Abstract**

An ideal diode circuit comprises a capacitor unit and a transistor unit electrically connected thereto, a voltage conversion unit electrically connected to the capacitor unit and the transistor unit respectively and configured to charge the capacitor unit via a parasitic diode in the transistor unit, the input end of the control unit electrically connected to the capacitor unit, the output end of the control unit electrically connected to the control end of the transistor unit, the control unit configured to output a first driving signal or a second driving signal based on the voltage signal of the capacitor unit, drive the transistor unit to turn off under the first driving signal, or drive the transistor unit to turn on under the second driving signal.

## Description

### TECHNICAL FIELD

The present application relates to the technical field of semiconductor circuit, in particular to an ideal diode circuit.

### BACKGROUND

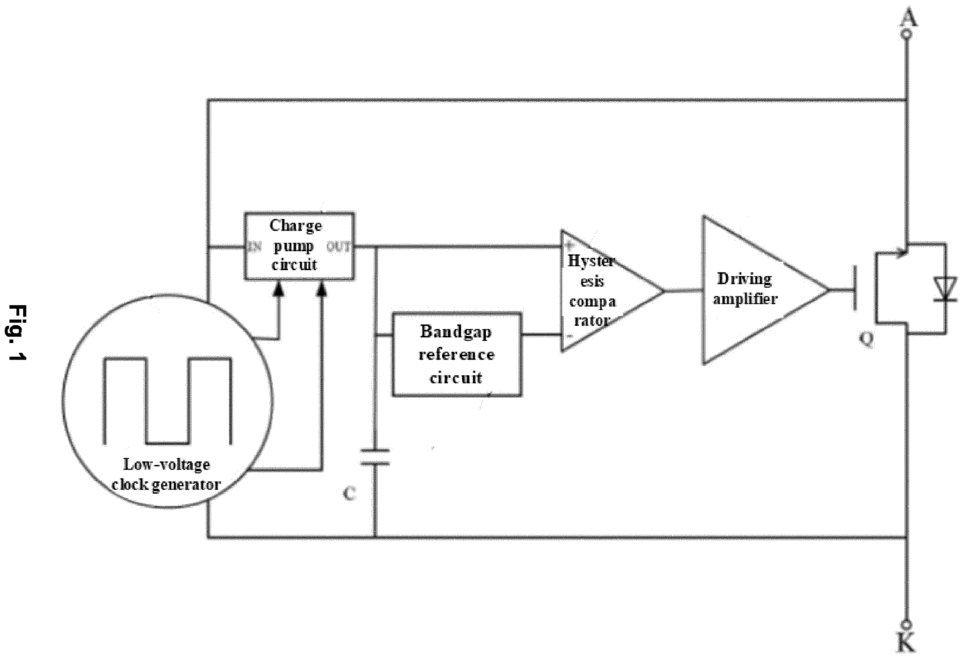

An ideal diode refers to a diode with a forward voltage drop of 0 and a reverse leakage current of 0. The conventional scheme of the ideal diode is shown in Fig.1. The determination of upper and lower limits of capacitor voltage is completed by reference + hysteresis comparator, which is a simple analog control mode, and the design of hysteresis comparator is also complicated. In addition, under high temperature and low current, the forward body diode voltage VF of MOSFET is small, and the charge pump pumping ability is weak, which can lead to the condition that the upper limit voltage VCAPH can not be pumped all the time, and the hysteresis comparator clock can not reach the flip condition, which leads to the ideal diode circuit unable to turn on MOSFET and unable to work normally and periodically.

For example, with setting VCAPL=5V and VCAPH=6V, the capacitor voltage VF is small under high temperature and small current, and the pumping ability of the charge pump circuit is weak, so that the upper limit of the output voltage only reaches 5.8V, which cannot reach the target upper limit voltage of the comparator of 6V. Meanwhile, the output of the hysteresis comparator is always low, and the MOSFET cannot be turned on, and the voltage drop across the MOSFET will always be high.

Therefore, an ideal diode circuit with high reliability is urgently needed.

The above information disclosed in the background is only used to enhance the understanding of the background of the present disclosure, so it may contain information that has not be part of the prior art known to one having ordinary skills in the art.

### SUMMARY

In order to solve the above problems, the present disclosure provides the following technical scheme.

An ideal diode circuit comprises:
a capacitor unit and a transistor unit electrically connected thereto;
a voltage conversion unit electrically connected to the capacitor unit and the transistor unit respectively, and configured to charge the capacitor unit via a parasitic diode in the transistor unit; and
a control unit, an input end of the control unit electrically connected to the capacitor unit and an output end of the control unit electrically connected to a control end of the transistor unit, wherein the control unit is configured to output a first driving signal or a second driving signal based on a voltage signal of the capacitor unit, drive the transistor unit to turn off under the first driving signal, and drive the transistor unit to turn on under the second driving signal.

In an optional embodiment of the present disclosure, the control unit comprises:
a trigger circuit, a control end of the trigger circuit electrically connected to the first end of the capacitor unit, and the trigger circuit configured to output the first driving signal or the second driving signal based on the voltage signal of the capacitor unit; and
a driving circuit, an input end of the driving circuit electrically connected to the output end of the trigger circuit, the output end of the driving circuit electrically connected to the control end of the transistor unit, the driving circuit configured to drive the transistor unit to turn off under the first driving signal, and drive the transistor unit to turn on under the second driving signal.

In an optional embodiment of the present disclosure, the trigger circuit comprises:
a voltage comparison device, an input end of the voltage comparison device electrically connected to the first end of the capacitor unit, and the voltage comparison device configured to output a timing trigger signal in a case where the voltage signal of the capacitor unit is less than a preset reference voltage;
a timing trigger device, an input end of the timing trigger device electrically connected to an output end of the voltage comparison device, and an output end of the timing trigger device electrically connected to the input end of the driving circuit, and the timing trigger device configured to start timing under the timing trigger signal, output the first driving signal, and output the second driving signal after a preset periodical duration.

In an optional embodiment of the present disclosure, the timing trigger device is a constant turn-off time generator.

In an optional embodiment of the present disclosure, the voltage conversion unit comprises:
a charge pump, electrically connected to the capacitor unit and the transistor unit respectively;
a low-voltage clock, electrically connected to the charge pump and the capacitor unit respectively, and configured to drive the charge pump to operate in a case where the voltage signal of the capacitor unit is less than a preset reference voltage.

In an optional embodiment of the present disclosure, the transistor unit comprises a metal oxide semiconductor field effect transistor.

In an optional embodiment of the present disclosure, the capacitor unit comprises a plurality of capacitors paralleled connected.

In an optional embodiment of the present disclosure, the ideal diode circuit further comprises:
a high-voltage isolation circuit, electrically connected to the capacitor unit, the transistor unit, and the voltage conversion unit, and configured to turn off the electrical connection between the transistor unit and the capacitor unit and/or the voltage conversion unit in a case where the voltage at two ends of the transistor unit is greater than a preset safe voltage.

In an optional embodiment of the present disclosure, the high-voltage isolation circuit comprises:
a voltage detection device, electrically connected to the transistor unit and configured to detect the voltage at two ends of the transistor unit;
a turn-off device, electrically connected the transistor unit to the capacitor unit and/or the voltage conversion unit, and configured to turn off the electrical connection between the transistor unit and the capacitor unit and/or the voltage conversion unit in a case where the voltage at two ends of the transistor unit is greater than the preset safe voltage.

In an optional embodiment of the present disclosure, the transistor unit is an N-channel MOS field effect transistor.

In the ideal diode circuit provided by the embodiment of the present disclosure, an input end of the control unit is electrically connected to the capacitor unit and an output end of the control unit is electrically connected to a control end of the transistor unit, and the control unit is configured to output a first driving signal or a second driving signal based on a voltage signal of the capacitor unit, and to drive the transistor unit to turn off under the first driving signal, or drive the transistor unit to turn on under the second driving signal. Even under the case of high temperature and small current and the voltage drop at two ends of the capacitor unit not reach the set upper limit voltage, the control unit can periodically control the conduction and closure of the transistor unit according to the preset period, and trigger to pump the capacitor unit after turning off the transistor unit MOSFET. In a case where the capacitor unit is charged for a fixed period, the transistor unit is turned on again without waiting for an accurate set voltage upper limit, thus realizing the operation requirements under extreme conditions and having higher reliability.

### BRIEF DESCRIPTION OF THE DRAWINGS

The drawings illustrated herein are used to provide a further understanding of the disclosure and form part of the disclosure, and the schematic embodiments of the disclosure and its description are used to interpret the disclosure and do not constitute an undue limitation of the disclosure. In the drawing:
Fig. 1 is a circuit diagram of a conventional ideal diode circuit.
Fig. 2 is a circuit schematic diagram of an ideal diode circuit according to an embodiment of the present disclosure.
Fig. 3 is a circuit schematic diagram of an ideal diode circuit according to an embodiment of the present disclosure.
Fig. 4 is an operation waveform diagram of each device in the ideal diode circuit according to the embodiment of the present disclosure.
where: 10. ideal diode circuit; 110, capacitor unit; 120, transistor unit; 130, voltage conversion unit; 140, control unit.

### DETAILED DESCRIPTION OF THE EMBODIMENTS

For the purposes, technical aspects and advantages of the embodiments of the present disclosure to be clearer for understanding, a detailed description of the technical aspects of the embodiments of the present disclosure will be given below in conjunction with the accompanying drawings in which it will be apparent that the described embodiments are part of, but not all of, the embodiments of the present disclosure. It should be noted that, without conflict, the embodiments in the present application and the component features in the embodiments may be combined with each other.

The ideal diode refers to the diode with the forward voltage drop of 0 and the reverse leakage current of 0. The conventional scheme of ideal diode is shown in Fig.1. The determination of upper and lower limits of capacitor voltage is completed by reference + hysteresis comparator, which is a simple analog control mode, and the design of hysteresis comparator is also complicated. In addition, under high temperature and low current, the forward body diode voltage VF of MOSFET is small, and the charge pump pumping ability is weak, which can lead to the condition that the upper limit voltage VCAPH can not be pumped all the time, and the hysteresis comparator clock can not reach the flip condition, which leads to the ideal diode circuit unable to turn on MOSFET and unable to operate normally and periodically.

For example, with setting VCAPL=5V and VCAPH=6V, the capacitor voltage VF is small under high temperature and small current, and the pumping ability of the charge pump circuit is weak, so that the upper limit of the output voltage only reaches 5.8V, which cannot reach the target upper limit voltage of the comparator of 6V. Meanwhile, the output of the hysteresis comparator is always low, the MOSFET cannot be turned on, and the voltage drop at two ends of the MOSFET will always be high.

Therefore, an ideal diode circuit with high reliability is urgently needed.

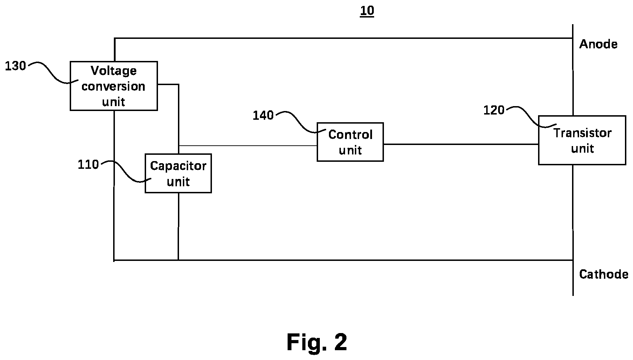

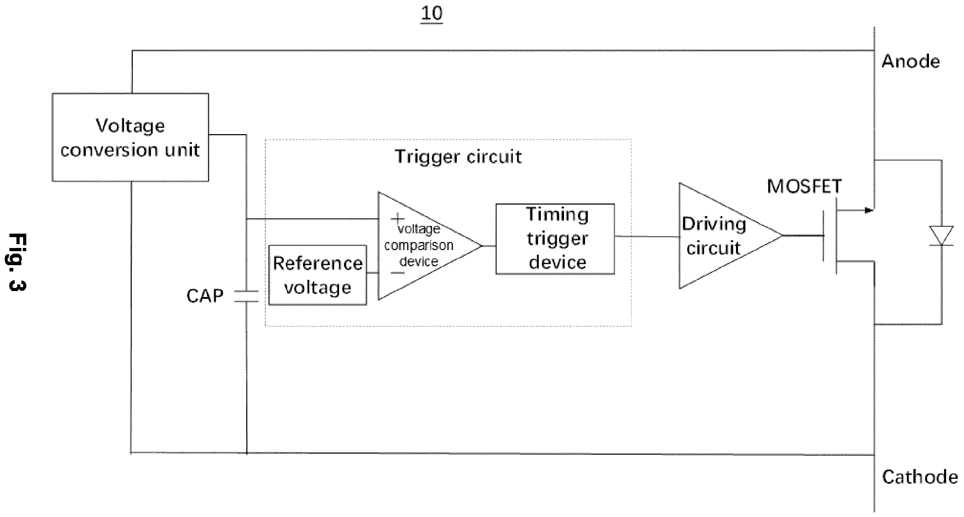

With reference to Fig. 2 and Fig. 3, based on the above technical problems, the embodiment of the present disclosure provides an ideal diode circuit 10 comprising a capacitor unit 110, a transistor unit 120, a voltage conversion unit 130, and a control unit 140, wherein:

The capacitor unit 110 and the transistor unit 120 are electrical connected with each other. The capacitor unit 110 refers to a device for storing electric charges and can comprise for example one capacitor unit 110 or a plurality of capacitor units 110 connected in series with each other. The transistor unit 120 comprises one or more transistors which is a device consisting of three layers of impurity semiconductors and having three electrodes, also called a semiconductor transistor, a triode transistor, or the like, can be a common transistor, a field effect transistor, a thyristor or the like, and is not specifically limited herein.

The voltage conversion unit 130 is electrically connected to the capacitor unit 110 and the transistor unit 120 respectively and configured to charge the capacitor unit 110 via a parasitic diode in the transistor unit 120. The voltage conversion unit 130 can be a transformer such as a capacity voltage converter or the like, via which the capacitor unit 110 is charged so that the voltage between two plates of the capacitor unit 110 is greater than the preset reference voltage.

The input end, i.e., input port of the control unit 140 is electrically connected to the capacitor unit 110 and the output end, i.e., output port of the control unit 140 is electrically connected to the control end, i.e., the control port configured to receive the control signal, of the transistor unit 120. The control unit 140 is configured to periodically output a first driving signal or a second driving signal based on a voltage signal of the capacitor unit 110 or according to an actual charging and discharging process of the capacitor unit 110, and to drive the transistor unit 120 to turn off under the first driving signal or to drive the transistor unit 120 to turn on under the second driving signal. The control unit 140 can be an integrated chip or a control circuit comprising different logic units. The embodiment of the present disclosure is not specifically limited and can be flexibly adjusted according to the actual situation. For example, the transistor inside the transistor unit 120 is an N-type transistor, the first driving signal can be a low-level signal, and the corresponding second driving signal can be a high-level signal, so that the transistor unit 120 can be turned off under the low-level signal and turned on under the high-level signal. Of course, this is only an example of the types of the first driving signal and the second driving signal which can be flexibly adjusted according to the types of the transistors in the transistor unit 120 and is not specifically limited here.

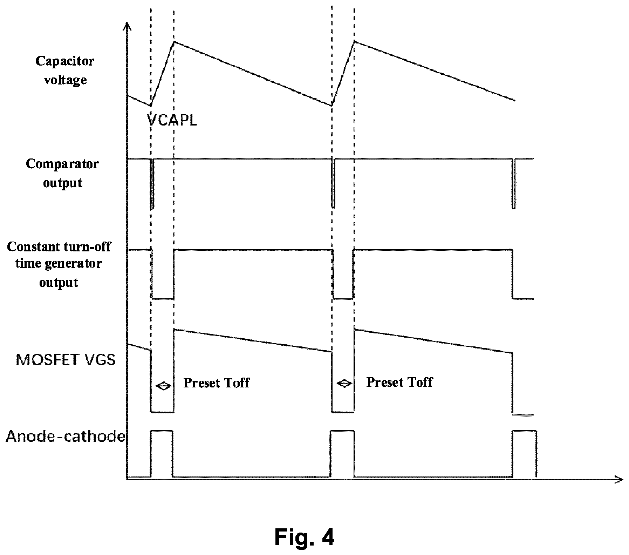

The operation principle of the ideal diode provided by the embodiment of the disclosure is briefly introduced as follows:
With reference to Fig. 2 and Fig. 4, the control unit 140 outputs the first driving signal or the second driving signal based on the voltage signal of the capacitor unit 110, drives the transistor unit 120 to turn off under the first driving signal, and drives the transistor unit 120 to turn on under the second driving signal. For example, in a case where the voltage signal at two ends of the capacitor unit 110 is less than the preset reference voltage, the control unit 140 outputs the first driving signal. Under the first driving signal, the transistor unit 120 is driven to turn off. Under the second driving signal, the transistor unit 120 is driven to turn on. The voltage drop at two ends of the transistor unit 120 (MOSFET) is reduced from VF to I*Ron which is about tens of mV, and the ideal diode function is realized.

With the voltage drop at two ends of the transistor unit 120 decreasing and the voltage at two ends of the capacitor unit 110 (CAP) is consumed to a preset reference voltage (i.e., the lower limit value VCAPL), the control unit 140 outputs the first driving signal again, drives the transistor unit 120 (MOSFET) to turn off under the first driving signal, and the voltage conversion unit 130 starts to operate and re-enters the period for charging the capacitor unit 110. After timing for a preset periodical duration Toff, the transistor unit 120 (MOSFET) is turned on again, to be cyclically and periodically operated.

In the ideal diode circuit 10 provided by the embodiment of the present disclosure, the input end of the control unit 140 is electrically connected to the capacitor unit 110 and the output end of the control unit 140 is electrically connected to the control end of the transistor unit 120, and the control unit 140 is configured to periodically output the first driving signal or the second driving signal based on the voltage signal of the capacitor unit, and to drive the transistor unit 120 to turn off under the first driving signal, or drive the transistor unit 120 to turn on under the second driving signal. Even under the condition of high temperature and small current and the voltage drop at two ends of the capacitor unit 110 does not reach the set upper limit voltage, the control unit 140 can periodically control the conduction and closure of the transistor unit 120 according to the preset period, and trigger to pump the capacitor unit 110 after turning off the transistor unit 120 (MOSFET). In a case where the capacitor unit 110 is charged for a fixed period, to turn on again without waiting for an accurate set voltage upper limit, thus realizing the operation requirements under extreme conditions and having higher reliability.

And with reference to Fig. 2 and Fig. 3, in an optional embodiment of the present disclosure, the control unit 140 comprises a trigger circuit and a drive circuit, wherein:

The control end of the trigger circuit is electrically connected to the first end of the capacitor unit 110. The trigger circuit outputs the first driving signal or the second driving signal based on the voltage signal of the capacitor unit 110, for example, periodically outputs the low-level signal or the high-level signal.

The trigger circuit is configured to trigger the driving circuit to start operating. The trigger signal of the trigger circuit is the voltage drop of the voltage signal at two ends of the capacitor unit 110. For example, if the voltage drop is greater than or equal to the preset reference voltage, the high-level signal is output, and if the voltage drop is less than the preset reference voltage, the low-level signal is output. Of course, this is only an example and does not constitute a specific limitation on the operation mode of the control unit 140 according to the embodiment of the present disclosure.

The input end of the driving circuit is electrically connected to the output end of the trigger circuit, and the output end of the driving circuit is electrically connected to the control end of the transistor unit 120. The driving circuit drives the transistor unit 120 to turn off under the first driving signal (e.g. the low-level signal) and drives the transistor unit 120 to turn on under the second driving signal (e.g. the high-level signal). The driving circuit can be an integrated chip or a preset electronic circuit. The embodiment of the present disclosure is not specifically limited and can be flexibly adjusted according to the actual situation. It only needs to realize the function of driving the transistor unit 120 to turn off based on the high-level signal and driving the transistor unit 120 to turn on under the high-level signal.

The trigger circuit of the embodiment of the present disclosure periodically outputs the low-level signal or the high-level signal based on the voltage signal of the capacitor unit 110, and the driving circuit drives the transistor unit 120 to turn off under the low-level signal, and drives the transistor unit 120 to turn on under the high-level signal, thus separating the generation the level signal from the driving the transistor unit 120, having independent functions and no influence on each other, and having higher reliability.

With reference to Fig. 3, in an optional embodiment of the present disclosure, the trigger circuit comprises a voltage comparison device and a timing trigger device, wherein:

The input end of the voltage comparison device is electrically connected to the first end of the capacitor unit 110, and the voltage comparison device is configured to output a timing trigger signal in a case where the voltage signal of the capacitor unit 110 is less than a preset reference voltage. The voltage comparison device is configured to compare the voltage at two ends of the capacitor unit 110 with the preset reference voltage which can be set according to the actual situation, such as the lower limit voltage VCAPL of the capacitor unit 110, etc, which is not specifically limited here, and can be flexibly adjusted according to the actual situation. The voltage comparison device can be a common comparator, rather than the traditional hysteresis comparator. Compared with the hysteresis comparator, the design of the common comparator is simpler and the cost is lower.

The input end of the timing trigger device is electrically connected to the output end of the voltage comparison device, and the output end of the timing trigger device is electrically connected to the input end of the driving circuit. The timing trigger device is configured to start timing under the timing trigger signal, output the first driving signal (for example, the low-level signal), and output the second driving signal (for example, the high-level signal) after the preset periodical duration.

The timing trigger device comprises at least two functional modules: a timing function module and a level signal generation module. The timing function module is configured to determine the signal generation period, i.e. generate the low-level signal via the level generation module from the starting time to the preset period time, and generate the high-level signal via the level signal generation module in the preset periodical duration Toff.

In an optional embodiment of the present disclosure, the capacitor unit 110 comprises a plurality of capacitors connected in parallel, in order to increase the capacitance capacity, to improve the working performance of the ideal diode circuit 10 in the embodiment of the present disclosure.

With reference to Fig. 3, In an optional embodiment of the present disclosure, the timing trigger device is a constant turn-off time generator, which is also called a constant turn-off time controller. The constant turn-off time generator is an electronic device that turns off in a fixed duration, and the fixed duration is the above preset periodical duration. The low-level signal is output in the periodical duration, the high-level signal is output after the periodical duration. The time starts timing again after receiving the next timing trigger signal (i.e., the trigger signal output in a case where the voltage signal at two ends of the capacitor unit 110 is less than the preset reference voltage). The constant turn-off time generator has the advantages of a simple structure, lower cost, and higher reliability. The ideal diode in the embodiment of the disclosure is realized based on the constant turn-off time generator and other unit devices, which have higher reliability and lower cost.

And, with reference to Fig. 2 and Fig. 3, in an optional embodiment of the present disclosure, the voltage conversion unit 130 comprises a charge pump and a low-voltage clock, wherein:
The charge pump is electrically connected to the capacitor unit 110 and the transistor unit 120 respectively, to charge the capacitor unit 110 via the diode in the transistor unit 120.

The low-voltage clock is electrically connected to the charge pump and the capacitor unit 110 respectively, and the low-voltage clock is configured to drive the charge pump to operate in a case where the voltage signal of the capacitor unit 110 is less than a preset reference voltage. The low-voltage clock generates a pulse signal or a digital signal, and the charge pump is driven by the pulse signal or the digital signal. The trigger signal of the low-voltage clock is the case of the voltage signal of the capacitor unit 110 smaller than the preset reference voltage.

The embodiment of the present disclosure realizes the charging of the capacitor unit 110 via the charge pump and the low-voltage clock. The charge pump has a strong pumping ability and can fill the electric quantity of the capacitor unit 110 in a short time, thus improving the operation efficiency of the ideal diode provided by the embodiment of the present disclosure.

In an optional embodiment of the present disclosure, the transistor unit 120 comprises a Metal-Oxide-Semiconductor Field-Effect Transistor (MOSFET), which is a voltage control component and a field-effect transistor controlling semiconductor (s) with the gate of a metal layer (m) across an oxide layer (o) by the effect of an electric field. The MOSFET has the advantages of high input impedance, low noise, good thermal stability, strong radiation resistance, and the like, as well as the advantages of small size, light weight, and the like. The embodiment of the disclosure provides the ideal diode in the embodiment of the disclosure based on the metal oxide semiconductor field effect transistor and other unit devices, having higher reliability and lower cost.

In an optional embodiment of the present disclosure, the ideal diode circuit 10 further comprises a high-voltage isolation circuit (not shown in Fig. 2 and Fig. 3).

The high-voltage isolation circuit is electrically connected to the capacitor unit 110, the transistor unit 120, and the voltage conversion unit 130, and configured to turn off the electrical connection between the transistor unit 120 and the capacitor unit 110 and/or the voltage conversion unit 130 in a case where the voltage at two ends of the transistor unit 120 is greater than the preset safe voltage.

In an optional embodiment of the present disclosure, the high-voltage isolation circuit comprises a voltage detection device and a turn-off device, wherein:
The voltage detection device is electrically connected to the transistor unit 120 and configured to detect the voltage at two ends of the transistor unit 120.

The turn-off device is electrically connected the transistor unit 120 to the capacitor unit 110 and/or the voltage conversion unit 130, and configured to turn off the electrical connection between the transistor unit 120 and the capacitor unit 110 and/or the voltage conversion unit 130 in a case where the voltage at two ends of the transistor unit 120 is greater than the preset safe voltage.

Once the voltage detection device detects that the voltage at two ends of the transistor unit 120 exceeds the preset safe voltage, the electrical connection between the transistor unit 120 and the capacitor unit 110 and/or the voltage conversion unit 130 can be immediately turned off by the turn-off device, so as to realize the protection of the capacitor unit 110 and the voltage conversion unit 130 and improve the safety and reliability of the ideal diode.

In an optional embodiment of the present disclosure, the capacitor unit 110 comprises one or more capacitors, and the energy storage capacity is improved by connecting a plurality of capacitors in parallel, thereby improving the operating performance of the ideal diode.

In an optional embodiment of the present disclosure, the transistor unit 120 is an N-channel MOS field effect transistor, which can support high-voltage driving, that is, the control of the high-level signal output by the capacitor unit 110 of the embodiment of the present disclosure, thereby improving the reliability and stability of the ideal diode circuit of the embodiment of the present disclosure.

The operation principle of the ideal diode provided by the above embodiment of the disclosure is briefly introduced as follows:
Further, with reference to Figs. 2-4, the voltage comparison device compares the voltage at two ends of the capacitor unit 110 (CAP) with the preset reference voltage. In a case where the voltage signal at two ends of the capacitor unit 110 is less than the preset reference voltage, the voltage comparator outputs the timing trigger signal, which can be a low-level signal. The constant turn-off time generator starts immediately after receiving the timing trigger signal, starts timing, and outputs a low-level signal, and the driving circuit drives the transistor unit 120 (MOSFET) to turn off under the low-level signal. The constant turn-off time generator outputs the high-level signal after the preset periodical duration Toff from the start of timing, drives the transistor unit 120 to turn on under the high-level signal, and reduces the voltage drop at two ends of the transistor unit 120 (MOSFET) from VF to I*Ron about tens of mV, thus realizing the ideal diode function.

With the voltage drop at two ends of the transistor unit 120 decreasing and the voltage at two ends of the capacitor unit 110 (CAP) consumed to the preset reference voltage (i.e., the lower limit value VCAPL), the voltage comparison device detects the voltage signal at two ends of the capacitor unit 110 less than the preset reference voltage and outputs a timing trigger signal. The constant turn-off time generator starts immediately after receiving the timing trigger signal, starts timing, and outputs a low-level signal. The driving circuit drives the transistor unit 120 (MOSFET) to turn off under the low-level signal, and the low-voltage clock drives the charge pump to start operating and re-enters the period for charging the capacitor unit 110. After timing for a preset periodical duration Toff, the transistor unit 120 (MOSFET) is turned on again, to be cyclically and periodically operated.

It should be mentioned that, in a case where the voltage of the capacitor unit 110 is less than the preset lower limit (VCAPL), the constant turn-off time generator is triggered to start timing, the high-level signal is output after the preset periodical duration Toff, and the transistor unit 120 is driven to turn on under the high-level signal. The constant turn-off time generator continuously outputs a low-level signal within the preset periodical duration Toff, and outputs a high-level signal outside the preset periodical duration Toff to control the transistor unit 120 (MOSFET) to turn on, so as to discharge the energy storage capacitor.

In the description of the present disclosure and the embodiments, it should be understood that the terms "top", "bottom", "height" and other directions or positional relations indicated are based on the orientation or positional relations shown in the drawings, and are only for the convenience of describing the present disclosure and simplifies the description, and not to indicate or imply that the device or element referred to must have a specific orientation, to a specific orientation of construction and operation, and therefore cannot be construed as a limitation of the present disclosure.

In the present disclosure and the embodiments, unless otherwise expressly specified and qualified, the terms "set", "mounted", "connected", "disposed", "fixed" and other terms should be understood broadly, for example, can be a fixed connection, can also be a detachable connection, or integral; can be mechanically connected, can also be electrically connected, can also be communication, can be directly connected, can also be indirectly connected through an intermediate medium, can be two elements internal communication or the interaction of two elements. For those of ordinary skill in the art, the specific meaning of the above terms in the present disclosure may be understood on a case-by-case basis.

In the present disclosure and the embodiments, unless otherwise expressly specified and qualified, the first feature in the second feature of the "above" or "below" may include the first and second feature's direct contact, may also include the first and second features are not direct contact but through the contact of additional features between them. Moreover, the first feature is "above", "upper", and "on", and the second feature includes the first feature directly above and obliquely above the second feature, or simply indicates that the first feature is horizontally higher than the second feature. The first feature is "below", "lower", and "under" the second feature, including the first feature directly above and diagonally above the second feature, or simply indicating that the horizontal height of the first feature is less than that of the second feature.

The disclosure above provides a number of different embodiments or examples to implement the different structures of the present disclosure. In order to simplify the disclosure of the present disclosure, the parts and settings of a specific example are described above. Of course, they are only examples and are not intended to limit the present disclosure. In addition, the present disclosure may repeat the reference numbers and/or reference letters in different examples, and this repetition is for the purpose of simplification and clarity and does not in itself indicate the relationship between the various embodiments and/or settings in question. In addition, the present disclosure provides examples of various specific processes and materials, but those of ordinary skill in the art may be aware of the disclosure of other processes and/or the use of other materials.

Notwithstanding the description of the preferred embodiments of the present disclosure, but once those skilled in the art are aware of the basic concept of inventive step, additional changes and modifications may be made to these embodiments. Therefore, the appended claims are intended to be construed to include the preferred embodiment and all changes and modifications that fall within the scope of the present disclosure.

Obviously, one skilled in the art may make various alterations and variants to the present disclosure without departing from the spirit and scope of the present disclosure. Thus, if these modifications and variants of the present disclosure fall within the scope of the claims of the present disclosure and their equivalents, the present disclosure is also intended to include such modifications and variants.

## Claims

1. An ideal diode circuit (10), comprising:
a capacitor unit (110) and a transistor unit (120) electrically connected thereto;
a voltage conversion unit (130) electrically connected to the capacitor unit (110) and the transistor unit (120) respectively, and configured to charge the capacitor unit (110) via a parasitic diode in the transistor unit (120);
a control unit (140), an input end of the control unit (140) electrically connected to the capacitor unit (110), and an output end of the control unit (140) electrically connected to a control end of the transistor unit (120), wherein the control unit (140) is configured to output a first driving signal or a second driving signal based on a voltage signal of the capacitor unit (110), drive the transistor unit (120) to turn off under the first driving signal and drive the transistor unit (120) to turn on under the second driving signal.

2. The ideal diode circuit (10) according to claim 1, wherein the control unit (140) comprises:
a trigger circuit, a control end of the trigger circuit electrically connected to the first end of the capacitor unit (110), and the trigger circuit configured to output the first driving signal or the second driving signal based on the voltage signal of the capacitor unit (110); and
a driving circuit, an input end of the driving circuit electrically connected to the output end of the trigger circuit, an output end of the driving circuit electrically connected to the control end of the transistor unit (120), and the driving circuit configured to drive the transistor unit (120) to turn off under the first driving signal, and drive the transistor unit (120) to turn on under the second driving signal.

3. The ideal diode circuit (10) according to claim 2, wherein the trigger circuit comprises:
a voltage comparison device, an input end of the voltage comparison device electrically connected to the first end of the capacitor unit (110), and the voltage comparison device configured to output a timing trigger signal in a case where the voltage signal of the capacitor unit (110) is less than a preset reference voltage; and
a timing trigger device, an input end of the timing trigger device electrically connected to the output end of the voltage comparison device, an output end of the timing trigger device electrically connected to the input end of the driving circuit, and the timing trigger device configured to start timing under the timing trigger signal, output the first driving signal, and output the second driving signal after a preset periodical duration.

4. The ideal diode circuit (10) according to claim 3, wherein the timing trigger device is a constant turn-off time generator.

5. The ideal diode circuit (10) according to any one of claims 1 to 4, wherein the voltage conversion unit (130) comprises:
a charge pump, electrically connected to the capacitor unit (110) and the transistor unit (120) respectively; and
a low-voltage clock, electrically connected to the charge pump and the capacitor unit (110) respectively, and the low-voltage clock configured to drive the charge pump to operate in a case where the voltage signal of the capacitor unit (110) is less than a preset reference voltage.

6. The ideal diode circuit (10) according to any one of claims 1 to 5, wherein the transistor unit (120) comprises: a metal oxide semiconductor field effect transistor.

7. The ideal diode circuit (10) according to any one of claims 1 to 6, wherein the capacitor unit (110) comprises a plurality of capacitors connected in parallel.

8. The ideal diode circuit (10) according to any one of claims 1 to 7, further comprising:
a high-voltage isolation circuit electrically connected to the capacitor unit (110), the transistor unit (120), and the voltage conversion unit (130), and configured to turn off the electrical connection between the transistor unit (120) and the capacitor unit (110) and/or the voltage conversion unit (130) in a case where the voltage at two ends of the transistor unit (120) is greater than a preset safe voltage.

9. The ideal diode circuit (10) according to claim 8, wherein the high-voltage isolation circuit comprises:
a voltage detection device, electrically connected to the transistor unit (120) and configured to detect the voltage at two ends of the transistor unit (120); and
a turn-off device, electrically connected the transistor unit (120) to the capacitor unit (110) and the voltage conversion unit (130), and configured to turn off the electrical connection between the transistor unit (120) and the capacitor unit (110) and/or the voltage conversion unit (130) in a case where the voltage at two ends of the transistor unit (120) is greater than a preset safe voltage.

10. The ideal diode circuit (10) according to claim 6, wherein the transistor unit is an N-channel MOS field effect transistor.
